# EUROPEAN PATENT SPECIFICATION

(11) **EP 2 233 608 B1**
(45) Date of publication and mention of the grant of the patent: **23.03.2016**
(21) Application number: 09155882.5
(22) Date of filing: 23.03.2009
(51) Int. Cl.: C23C 18/18

(54) **Pre-treatment process for electroless nickel plating**
Vorbehandlungsverfahren für die stromfreie Nickelplattierung
Processus de prétraitement de placage de nickel anélectrolytique

(43) Date of publication of application: 29.09.2010
(73) Proprietor: Atotech Deutschland GmbH, 10553 Berlin (DE)
(72) Inventor: Zettelmeyer, Elisabeth, 10779, Berlin (DE)
(74) Representative: Wonnemann, Jörg

(56) References cited:
- JP-A- 2003 193 246
- US-A1- 2005 245 080

## Description

### Field of the Invention

The present invention relates to a surface finishing process in manufacture of printed circuit boards (PCB). The inventive process suppresses extraneous nickel plating on a substrate having a copper patterned surface after activation with an ionic palladium activator.

### Background of the Invention

Surface finishing processes in the manufacture of printed circuit boards add bondable surfaces areas to a printed circuit board where active and passive components can be mechanically and electrically contacted to the PCB. Frequently applied surface finishing processes are the ENIG process (Electroless Nickel Immersion Gold) and Ni/Pd(/Au) processes. In both types of processes, a copper surface of a printed circuit board is activated with an activation composition containing a noble metal ion followed by electroless deposition of nickel.

An activation of a copper surface prior to electroless nickel plating is required because copper is classified as a non-catalytic metal for electroless deposition of for example nickel deposited from hypophosphite containing electrolytes (W. Riedel, Electroless Nickel Plating, ASM International, reprint 1998, p. 189). The purpose of the activation step is to deposit an immersion coating of a catalyst on the copper surface. The catalyst lowers the activation energy and allows the nickel to deposit on the copper surface. Examples of catalysts are palladium and ruthenium (Printed Circuits Handbook, Ed.: C. F. Coombs, Jr., McGraw-Hill, 2001, p. 32.3). Usually, a palladium seed layer is immersion plated onto the copper surface, wherein the palladium ions are deposited onto the copper surface, reduced by copper to metallic state palladium and copper ions are released into the immersion plating bath. The substrate surface areas are then composed of metallic palladium and serve as seeds for the following electroless nickel plating.

It is important to rinse the substrate carefully between activation of the copper surface and electroless nickel plating to remove all excessive noble metal ions. Otherwise precipitates formed of noble metal hydroxides can lead to extraneous (uncontrolled) nickel deposition around individual copper features on the substrate surface and surfaces made of plastic materials. The phrase 'plastic materials' comprises bare PCB laminates, solder masks and photoimageable resists such as dry film resists. The noble metal hydroxide precipitates serve as seeds for uncontrolled deposition of nickel. Typical phenomena of extraneous nickel plating are nickel bridges and nickel feet. Extraneous nickel plating can lead for example to circuit shorts, especially in high density circuits with line and space widths of 75 µm or less. Extraneous nickel deposits have a weak adhesion on laminate and solder mask surfaces and can fracture off the PCB and also cause circuit shorts at other locations of the PCB. Nickel bridges between individual copper bond pads or copper trenches can directly result in circuit shorts. Nickel feet around a copper bond pad in fine line circuits also can cause circuit shorts by bridging individual copper bond pads. In addition, palladium ions or precipitates formed thereof adsorbed onto the copper bond pads should not be removed during the activation pre-treatment before electroless nickel plating in order to prevent skip plating. Skip plating is a phenomenon wherein an incomplete nickel plating occurs on the copper bond pads which leads to failures during bonding.

The problem of extraneous plating of nickel is solved in the prior art by different approaches:
Watanabe et al. investigated ionic palladium activators containing ammonium chloride as a complexing agent and sodium dodecyl sulfate as a surfactant.

They claim a negatively charged palladium-chloro complex as the active component in their activator composition which is repulsed by the negatively charged surfactant preferably adsorbed on the dielectric surface areas surrounding the copper bond pads (K. Watanabe, T. Nishiwaki, H. Honma, International Society of Electrochemistry-55th Annual Meeting, Thessaloniki, 19-24 September 2004).

US 2001/0040047 teaches a method which reduces bridging that can occur during plating. Said method comprises the following steps: contacting a circuitized substrate with a swelling agent, treating the substrate with a composition of an alkaline permanganate, a chromate or chlorite salt followed by applying a metal layer on the treated circuitized portion of the substrate. The method is an alternative to the process according to the present invention as no palladium ion activation is applied.

The patent EP 0 707 093 discloses an activator which will selectively activate the copper surfaces for electroless nickel plating and thereby minimize or eliminate extraneous plating. Said activator composition comprises an imidazole compound and may further contain palladium ions.

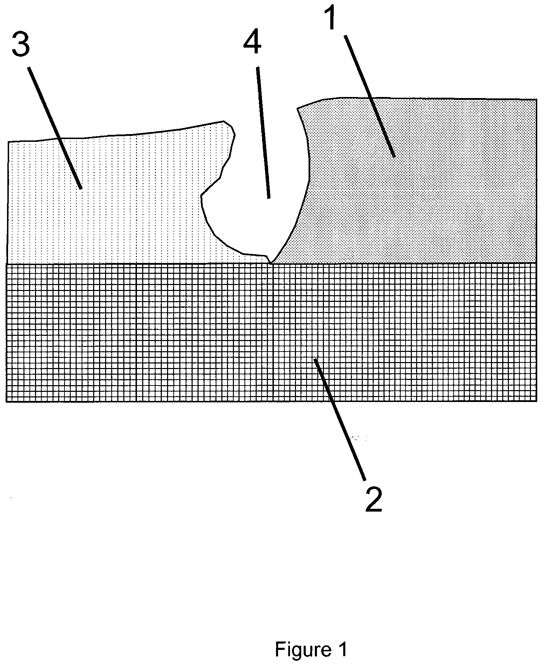

Excess palladium ions during activation of a copper surface tend to hydrolyze in the rinse step(s) applied before electroless plating of nickel and form palladium-containing precipitates. Said precipitates can be adsorbed onto surface areas of a PCB that are made of polymeric materials or can be trapped in cavities formed between structural features made of copper and polymeric materials, e.g., laminate, photoresist and/or solder mask on a PCB surface (see Figure 1). Said precipitates can get reduced to metallic state palladium by the reducing agent present in the successive electroless nickel plating bath. Nickel plating will occur on such reduced palladium precipitates. If the reduced palladium is present on surface areas of the PCB substrate other than the copper surface, unwanted extraneous nickel plating can occur and lead to circuit shorts.

A rinse step after activation is required in order to remove all excess palladium ions before contacting the substrate with the electroless nickel plating composition. On the other hand, hydrolysis and precipitation of ionic palladium occurs preferably during such rinse steps. Therefore, at least one rinse step is done in a rinse solution consisting of diluted sulfuric acid. But in case of high density circuits the sulfuric acid rinse is not sufficient to remove the undesired palladium ions and palladium hydroxide precipitates. Extraneous nickel plating occurs during successive electroless nickel plating leading to circuit shorts.

### Brief Description of the Figures

Figure 1 shows a schematic cross section of a PCB. A copper bond pad 1 deposited on a PCB substrate **2** and a solder mask **3** form a cavity **4** between copper bond pad **1** and solder mask **3.** Palladium ions and/or precipitates formed thereof may be trapped in cavity **4** and may not be removed during rinse steps between activation and electroless nickel plating. Said trapped palladium ions and/or precipitates formed thereof may serve as seeds for extraneous nickel plating and lead to a nickel foot around copper bond pad **1.**
Figure 2 shows a top view of a copper bond pad with a nickel deposit **5** on a PCB substrate **2** with extraneous nickel plating **6** around the nickel coated copper bond pad **5** (Example 1).
Figure 3 shows a top view of a copper bond pad with a nickel deposit 5 on a PCB substrate **2** without extraneous nickel plating. Substrate **2** was contacted with the inventive pre-treatment composition prior to electroless nickel plating (Example 2).
Figure 4 shows a copper bond pad **1** on a PCB substrate **2** having a nickel coating **6** and a gold coating 7 derived from comparative Example 3. The nickel foot **8** has a widths almost double as that of the desired nickel coating **6.**
Figure 5 shows a copper bond pad **1** on a PCB substrate **2** having a nickel coating **6** and a gold coating **7** derived from Example 4. The widths of the nickel foot **8** is reduced by 2/3 compared to Example 3.

### Detailed Description of the Invention

It is an object of the present invention to provide a process for electroless deposition of nickel onto a copper surface of a PCB substrate which suppresses extraneous nickel plating.

The deposition of ionic palladium or precipitates formed thereof shall only occur on surface areas of the PCB substrate designated for nickel plating. This can be achieved by applying the inventive pre-treatment composition for electroless nickel plating. Said pre-treatment composition comprises at least two different types of acids wherein one type of acid is an amino carboxylic acid. The palladium ions and precipitates formed thereof can be easily rinsed off from the plastic material surface of the PCB substrate by contacting the PCB substrate after activation with the pre-treatment composition according to the invention. Extraneous nickel plating in areas of the PCB substrate surface not desired for nickel plating is then suppressed.

The process for deposition of electroless nickel according to the present invention comprises the following steps:
i. contacting a substrate containing a copper surface with a noble metal ion containing composition; thereafter
ii. contacting the copper containing surface with a composition comprising an organic amino carboxylic acid; and
iii. electroless plating of nickel onto said treated copper containing surface.

Compositions for activation of copper surfaces for electroless nickel plating are well known in the art (K. Johal, SMTA International, Chicago, October 2001, Proceedings of the Technical Program, 612-620). Acidic solutions of palladium ions are frequently applied for said purpose. Such solutions comprise at least one acid, at least one source of palladium ions and optionally a surfactant. The at least one acid is selected from the group comprising hydrochloric acid, sulfuric acid, toluene sulfonic acid and methane sulfonic acid. The concentration of the at least one acid preferably ranges from 25 g to 150 g/l, more preferred 50 g/l to 100 g/l. The at least one source of palladium ions preferably is selected from the group comprising palladium chloride, palladium sulphate and palladium acetate. The concentration of the at least one source of palladium ions ranges from 10 mg/l to 100 mg/l, more preferred from 30 mg/l to 70 mg/l. The PCB substrate is contacted with such an activator solution at a temperature in the range of 10 °C to 40 °C, more preferred 20 °C to 30 °C for 30 s to 300 s, more preferred 60 s to 240 s.

The pre-treatment composition for electroless nickel plating comprises a mixture of at least two different types of acids, wherein one type of acid is an organic amino carboxylic acid.

In one embodiment of the invention, the at least one amino carboxylic acid is selected from compounds represented by formula 1 or formula 2: 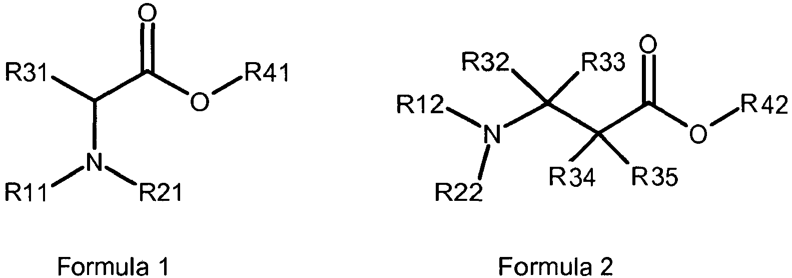 wherein R11, R12, R21 and R22 are independently selected from the group consisting of H, C₁-C₄ alkyl, linear or branched; R31, R32, R33, R34 and R35 are independently selected from the group consisting of H, phenyl, benzyl, C₁-C₄ alkyl, linear or branched, substituted or unsubstituted, wherein the substituents are selected from the group consisting of -OH, -SH, -NH₂, -COOH; R41 and R42 are independently selected from the group consisting of H, C₁-C₄ alkyl, linear or branched, or a suitable counter ion for example Na⁺, K⁺, NH₄⁺.

Preferably R11, R12, R21 and R22 are selected from H, methyl and ethyl. Preferably R31, R32, R33, R34 and R35 are independently selected from the group consisting of H, methyl, ethyl, -CH₂OH, -CH₂NH₂, -CH₂COOH, -CH₂CH₂OH, -CH₂CH₂NH₂, -CH₂CH₂COOH, -CH₂SH, -CH₂CH₂SH and -CH₂CONH₂.

Preferred organic amino carboxylic acids are selected from the group consisting of alanine, asparagine, aspartic acid, cysteine, glutamic acid, glycine, isoleucine, leucine, lysine, serine, methionine, threonine, valine, N,N-dimethyl glycine, β-alanine, β-leucine, β-isoleucine, β-glutamine, β-glutamic acid, β-methionine, β-asparagic acid.

The at least one amino carboxylic acid is present in the pre-treatment composition in a concentration of 0.1 g/l to 100 g/l, more preferred 0.5 g/l to 50 g/l and most preferred 1 g/l to 15 g/l.

The at least one acid present in the pre-treatment composition which is not an amino carboxylic acid preferably can be selected from the group consisting of sulfuric acid, hydrochloric acid, toluene sulfonic acid, methane sulfonic acid, formic acid and acetic acid. The total amount of acids which are not organic amino carboxylic acids ranges from 25 g/l to 150 g/l, more preferred from 50 g/l to 100 g/l. The most preferred mixture of acids in the pre-treatment composition consists of sulphuric acid and an organic amino carboxylic acid.

The pre-treatment composition according to the present invention may further contain a surfactant.

The pH value of the pre-treatment composition is preferably < 1.

At least one additional rinse step between process steps i. and ii. using essentially water is optional. At least one additional rinse step between process step ii. and iii. Is applied using essentially water is mandatory.

The substrate having an activated copper surface is contacted with the inventive pre-treatment composition at a temperature of 10 °C to 50 °C, more preferred 15 °C to 40 °C. The contact time ranges from 30 s to 10 min, more preferred 1 min to 6 min.

There is no risk of nickel skip plating as re-dissolution of palladium from the copper surface does not occur when contacting the PCB substrate with the inventive pre-treatment composition. Skip plating means a lack of electroless nickel plating on copper surface areas where the copper is not sufficiently activated. Furthermore, the pre-treatment composition is very tolerant against drag over from the activator tank.

### Examples

The invention will now be illustrated by reference to the following non-limiting examples.

### Example 1 (comparative experiment)

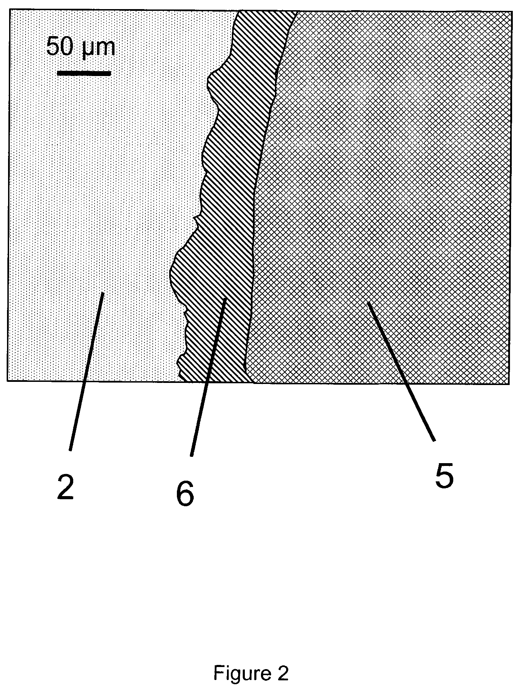

A PCB substrate 2 having electroplated copper bond pads was contacted with an activator composition comprising 50 mg/l Pd²⁺ ions and 90 g/l sulfuric acid at a temperature of 23 °C for 3 min. In the next step said substrate was rinsed with a pre-treatment solution consisting of 60 g/l sulfuric acid at 20 °C for 5 min and then rinsed with water. As the final step nickel was deposited from an electroless nickel electrolyte (Aurotech^{®} CNN, a product of Atotech Deutschland GmbH). The substrate surface was then investigated with an optical microscope (Figure 2). Extraneous nickel plating **6** occurred around nickel coated copper bond pads **5.**

### Example 2

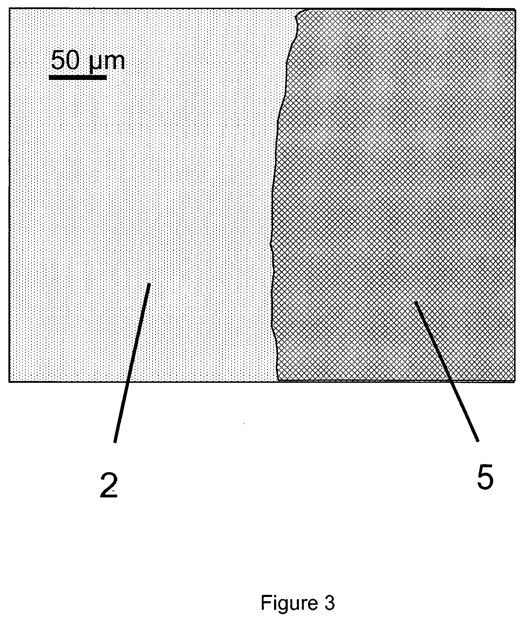

A PCB substrate having electroplated copper and solder mask surface areas was contacted with an activator composition comprising 50 mg/l Pd²⁺ ions and 90 g/l sulfuric acid at a temperature of 23 °C for 3 min. In the next step said substrate was rinsed with a pre-treatment solution consisting of 60 g/l sulfuric acid and 3 g/l alanine at 20 °C for 5 min and then rinsed with water. As the final step nickel was deposited from an electroless nickel electrolyte (Aurotech^{®} CNN, a product of Atotech Deutschland GmbH). The substrate surface was then investigated with an optical microscope (Figure 3). No extraneous nickel plating occurred on the PCB substrate **2** around nickel coated copper bond pads **5.**

### Example 3 (comparative)

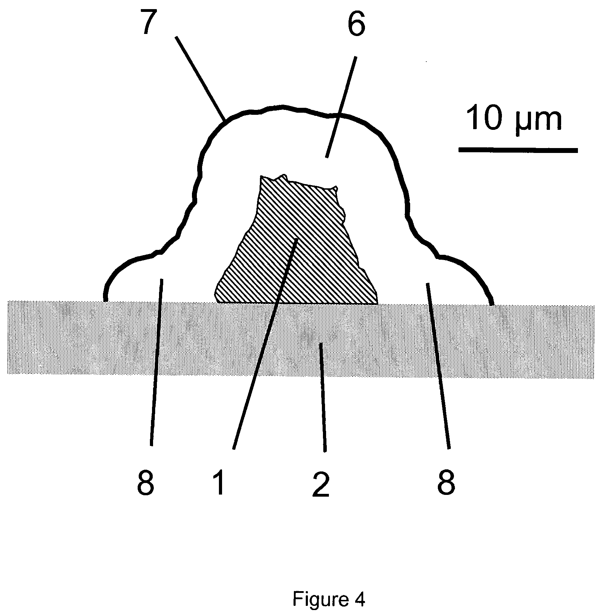

Copper bond pads 1 on the surface of a PCB substrate 2 were activated with a solution of palladium ions comprising 50 mg/l Pd²⁺ ions and 90 g/l sulfuric acid at a temperature of 23 °C for 3 min. In the next step said substrate was rinsed with a pre-treatment solution consisting of 60 g/l sulfuric acid at 20 °C for 5 min and then rinsed with water. As the final step nickel was deposited from an electroless nickel electrolyte (Aurotech^{®} CNN, a product of Atotech Deutschland GmbH) and coated with a thin gold layer from an immersion gold electrolyte (Aurotech^{®} SF Plus, a product of Atotech Deutschland GmbH). Cross-sections of nickel 6 and gold 7 coated copper bond pads 1 were made and investigated with a scanning electron microscope (SEM) in order to determine the nickel foot **8** around copper bonding pads **1.** One typical nickel foot **8** observed is shown in Figure 4. The nickel foot **8** has a width which is about 200 % of the deposited nickel coating **6** on the copper bond pad **1.**

### Example 4

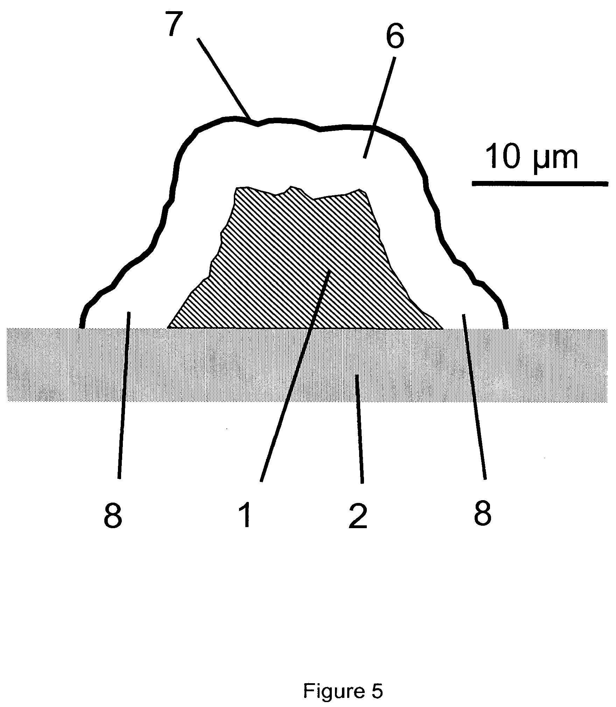

Copper bond pads **1** on the surface of a PCB substrate **2** were activated with a solution of palladium ions as described in example 3, rinsed with water and then contacted with an inventive pre-treatment composition consisting of 60 g/l sulfuric acid and 3 g/l alanine, rinsed with water and then coated with nickel and gold as described in example 3. Cross-sections of nickel **6** and gold **7** coated copper bond pads **1** were made and investigated with a scanning electron microscope (SEM) in order to determine the nickel foot **8** around copper bonding pads **1.** One typical nickel foot **8** observed is shown in Figure 5 and has a width which is about 133 % of the deposited nickel coating **6** on the copper bond pad **1.**

## Claims

1. A process for deposition of electroless nickel comprising the following steps:
i. contacting a substrate containing a copper surface with a noble metal ion containing composition; thereafter
ii. contacting the copper containing surface with a composition comprising an organic amino carboxylic acid; and
iii. electroless plating of nickel onto said treated copper containing surface.

2. The process according to claim 1 wherein the noble metal ion is palladium.

3. The process according to any of the foregoing claims wherein the pre-treatment composition in step ii. further comprises an acid selected from the group consisting of sulfuric acid, hydrochloric acid, toluene sulfonic acid, methane sulfonic acid, formic acid and acetic acid.

4. The process according to claim 3 wherein the concentration of the further acid ranges from 25 g/l to 150 g/l.

5. The process according to any of the foregoing claims wherein the pre-treatment composition contains at least one amino carboxylic acid represented by formula 1 and formula 2: 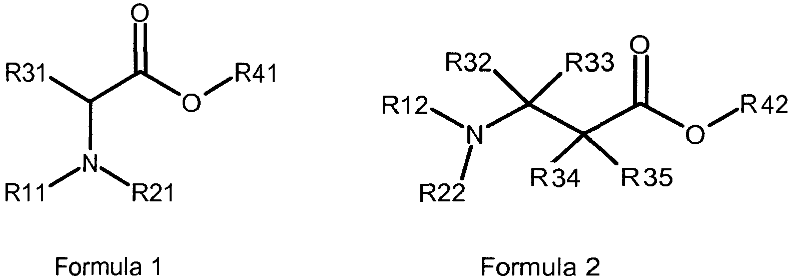 wherein R11, R12, R21 and R22 are independently selected from the group consisting of H, C₁-C₄ alkyl, linear or branched; R31, R32, R33, R34 and R35 are independently selected from the group consisting of H, phenyl, benzyl, C₁-C₄ alkyl, linear or branched, substituted or unsubstituted, wherein the substituents are selected from the group consisting of -OH, -SH, -NH₂, -COOH; R41 and R42 are independently selected from the group consisting of H, C₁-C₄ alkyl, linear or branched, or a suitable counter ion.

6. The process according to claim 5, wherein the suitable counter ion is selected from the group consisting of Na⁺, K⁺, NH₄⁺.

7. The process according to any of the foregoing claims, wherein R11, R12, R21 and R22 are selected independently from H, methyl and ethyl.

8. The process according to any of the foregoing claims, wherein R31, R32, R33, R34 and R35 are independently selected from the group consisting of H, methyl, ethyl, -CH₂OH, -CH₂NH₂, -CH₂COOH, -CH₂CH₂OH, -CH₂CH₂NH₂, -CH₂CH₂COOH, -CH₂SH, -CH₂CH₂SH and -CH₂CONH₂.

9. The process according to any of the foregoing claims, wherein the organic amino carboxylic acid is selected from the group consisting of alanine, asparagine, aspartic acid, cysteine, glutamic acid, glycine, isoleucine, leucine, lysine, serine, phenylalanine, methionine, threonine, valine, N,N-dimethyl glycine.

10. The process according to claim 1 wherein the organic amino carboxylic acid is selected from the group consisting of β-alanine, β-leucine, β-isoleucine, β-glutamine, β-glutamic acid, β-methionine, β-asparagic acid

11. The process according to any of the foregoing claims, wherein the concentration of the at least one amino carboxylic acid ranges from 0.1 g/l to 100 g/l.

12. The process according to any of the foregoing claims, wherein the copper surface is on a printed circuit board substrate.

## Patentansprüche

1. Verfahren zur Abscheidung von Nickel auf stromlosem Wege, das folgende Schritte umfasst:
i. Inberührungbringen eines Substrats mit einer Kupferoberfläche mit einer edelmetallionenhaltigen Lösung; danach
ii. Inberührungbringen der kupferhaltigen Oberfläche mit einer Zusammensetzung, die eine organische Aminocarbonsäure umfasst; und
iii. stromloses Abscheiden von Nickel auf der behandelten kupferhaltigen Oberfläche.

2. Verfahren nach Anspruch 1, bei dem es sich bei dem Edelmetallion um Palladium handelt.

3. Verfahren nach einem der vorhergehenden Ansprüche, bei dem die Vorbehandlungszusammensetzung in Schritt ii. ferner eine Säure aus der Gruppe bestehend aus Schwefelsäure, Salzsäure, Toluolsulfonsäure, Methansulfonsäure, Ameisensäure und Essigsäure umfasst.

4. Verfahren nach Anspruch 3, bei dem die Konzentration der weiteren Säure im Bereich von 25 g/l bis 150 g/l liegt.

5. Verfahren nach einem der vorhergehenden Ansprüche, bei dem die Vorbehandlungszusammensetzung mindestens eine durch die Formel 1 und Formel 2 wiedergegebene Aminocarbonsäure enthält: 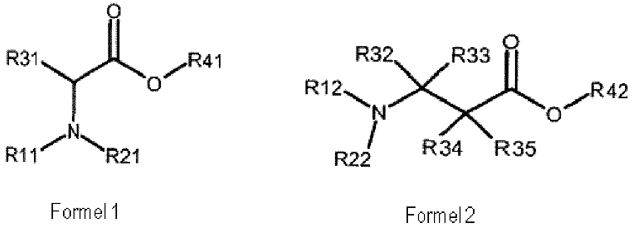 wobei R11, R12, R21 und R22 unabhängig voneinander aus der Gruppe bestehend aus H, C₁-C₄-Alkyl, linear oder verzweigt, ausgewählt sind; R31, R32, R33, R34 und R35 unabhängig voneinander aus der Gruppe bestehend aus H, Phenyl, Benzyl, C₁-C₄-Alkyl, linear oder verzweigt, substituiert oder unsubstituiert, ausgewählt sind, wobei die Substituenten aus der Gruppe bestehend aus -OH, -SH, -NH₂, -COOH ausgewählt sind; R41 und R42 unabhängig voneinander aus der Gruppe bestehend aus H, C₁-C₄-Alkyl, linear oder verzweigt, oder einem geeigneten Gegenion ausgewählt sind.

6. Verfahren nach Anspruch 5, bei dem das geeignete Gegenion aus der Gruppe bestehend aus Na⁺, K⁺, NH₄⁺ ausgewählt ist.

7. Verfahren nach einem der vorhergehenden Ansprüche, bei dem R11, R12, R21 und R22 unabhängig voneinander aus H, Methyl und Ethyl ausgewählt sind.

8. Verfahren nach einem der vorhergehenden Ansprüche, bei dem R31, R32, R33, R34 und R35 unabhängig voneinander aus der Gruppe bestehend aus H, Methyl, Ethyl, -CH₂OH, -CH₂NH₂, -CH₂COOH, -CH₂CH₂OH, -CH₂CH₂NH₂, -CH₂CH₂COOH, -CH₂SH, -CH₂CH₂SH und -CH₂CONH₂ ausgewählt sind.

9. Verfahren nach einem der vorhergehenden Ansprüche, bei dem die organische Aminocarbonsäure aus der Gruppe bestehend aus Alanin, Asparagin, Asparaginsäure, Cystein, Glutaminsäure, Glycin, Isoleucin, Leucin, Lysin, Serin, Phenylalanin, Methionin, Threonin, Valin, N,N-Dimethylglycin ausgewählt ist.

10. Verfahren nach Anspruch 1, bei dem die organische Aminocarbonsäure aus der Gruppe bestehend aus β-Alanin, β-Leucin, β-Isoleucin, β-Glutamin, β-Glutaminsäure, β-Methionin, β-Asparaginsäure ausgewählt ist.

11. Verfahren nach einem der vorhergehenden Ansprüche, bei dem die Konzentration der mindestens einen Aminocarbonsäure im Bereich von 0,1 g/l bis 100 g/l liegt.

12. Verfahren nach einem der vorhergehenden Ansprüche, bei dem sich die Kupferoberfläche auf einem Leiterplattensubstrat befindet.

## Revendications

1. Procédé de dépôt de nickel autocatalytique comprenant les étapes suivantes :
i. mise en contact d'un substrat contenant une surface de cuivre avec une composition contenant un ion de métal noble ; puis
ii. mise en contact de la surface contenant du cuivre avec une composition comprenant un acide aminocarboxylique organique ; et
iii. dépôt autocatalytique de nickel sur ladite surface contenant du cuivre traitée.

2. Procédé selon la revendication 1 dans lequel l'ion de métal noble est le palladium.

3. Procédé selon l'une quelconque des revendications précédentes dans lequel la composition de prétraitement dans l'étape ii. comprend en outre un acide choisi dans le groupe constitué de l'acide sulfurique, l'acide chlorhydrique, l'acide toluènesulfonique, l'acide méthanesulfonique, l'acide formique et l'acide acétique.

4. Procédé selon la revendication 3 dans lequel la concentration de l'acide supplémentaire est dans la plage de 25 g/l à 150 g/l.

5. Procédé selon l'une quelconque des revendications précédentes dans lequel la composition de prétraitement contient au moins un acide aminocarboxylique représenté par la formule 1 et la formule 2 : 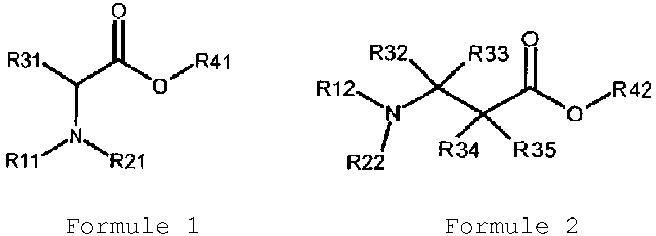 où R11, R12, R21 et R22 sont indépendamment choisis dans le groupe constitué de H, alkyle en C₁-C₄, linéaire ou ramifié ; R31, R32, R33, R34 et R35 sont indépendamment choisis dans le groupe constitué de H, phényle, benzyle, alkyle en C₁-C₄, linéaire ou ramifié, substitué ou non substitué, où les substituants sont choisis dans le groupe constitué de -OH, -SH, -NH₂, -COOH ; R41 et R42 sont indépendamment choisis dans le groupe constitué de H, alkyle en C₁-C₄, linéaire ou ramifié, ou un contre-ion adapté.

6. Procédé selon la revendication 5, dans lequel le contre-ion adapté est choisi dans le groupe constitué de Na⁺, K⁺, NH₄⁺.

7. Procédé selon l'une quelconque des revendications précédentes, dans lequel R11, R12, R21 et R22 sont choisis indépendamment parmi H, méthyle et éthyle.

8. Procédé selon l'une quelconque des revendications précédentes, dans lequel R31, R32, R33, R34 et R35 sont indépendamment choisis dans le groupe constitué de H, méthyle, éthyle, -CH₂OH, -CH₂NH₂, -CH₂COOH, -CH₂CH₂OH, -CH₂CH₂NH₂, -CH₂CH₂COOH, -CH₂SH, -CH₂CH₂SH et -CH₂CONH₂.

9. Procédé selon l'une quelconque des revendications précédentes, dans lequel l'acide aminocarboxylique organique est choisi dans le groupe constitué de l'alanine, l'asparagine, l'acide aspartique, la cystéine, l'acide glutamique, la glycine, l'isoleucine, la leucine, la lysine, la sérine, la phénylalanine, la méthionine, la thréonine, la valine, la N,N-diméthylglycine.

10. Procédé selon la revendication 1 dans lequel l'acide aminocarboxylique organique est choisi dans le groupe constitué de la β-alanine, la β-leucine, la β-isoleucine, la β-glutamine, l'acide β-glutamique, la β-méthionine, l'acide β-asparagique.

11. Procédé selon l'une quelconque des revendications précédentes, dans lequel la concentration de l'au moins un acide aminocarboxylique est dans la plage de 0,1 g/l à 100 g/l.

12. Procédé selon l'une quelconque des revendications précédentes, dans lequel la surface de cuivre est sur un substrat de carte de circuit imprimé.
